# DEMANDE DE BREVET EUROPEEN

(11) **EP 2 765 607 A1**
(43) Date de publication de la demande: **13.08.2014**
(21) Numéro de dépôt: 14154719.0
(22) Date de dépôt: 11.02.2014
(51) Int. Cl.: H01L 27/12, H01L 21/762, H01L 29/66

(54) **Procédé de réalisation d'une couche semi-conductrice présentant au moins deux épaisseurs différentes**

(30) Priorité: 11.02.2013 FR 1351144
(71) Demandeur: COMMISSARIAT A L'ENERGIE ATOMIQUE ET AUX ENERGIES ALTERNATIVES, 75015 Paris (FR); STMicroelectronics (Crolles 2) SAS, 38920 Crolles (FR); STmicroelectronics SA, 92120 Montrouge (FR)
(72) Inventeur: Vinet, Maud, 38140 Rives (FR); Morand, Yves, 38000 Grenoble (FR); Niebojewski, Heimanu, 38000 Grenoble (FR)
(74) Mandataire: Hautier, Nicolas

(57) **Abrégé**

La présente invention propose notamment un procédé de réalisation d'une couche semi-conductrice (146) présentant au moins deux épaisseurs différentes (T_{Si1}, T_{Si2}) à partir d'un empilement de type semi-conducteur sur isolant comportant au moins un substrat (112) sur lequel sont disposées successivement une couche isolante (114) et une première couche semi-conductrice, le procédé comprenant au moins une séquence comportant les étapes suivantes:
• gravure de la première couche semi-conductrice de manière à ce que la première couche semi-conductrice soit continue et comprenne au moins une première zone dont l'épaisseur (t_{Si1}) est inférieure à l'épaisseur (t_{Si2}) d'au moins une deuxième zone ;
• oxydation de la première couche semi-conductrice pour former un film d'oxyde électriquement isolant à la surface de la première couche semi-conductrice de manière à ce que dans la première zone le film d'oxyde s'étende jusqu'à la couche isolante (114) ;
• retrait partiel du film d'oxyde de manière à mettre à nu la première couche semi-conductrice en dehors de la première zone ;
• formation sur l'empilement de couches d'une deuxième couche semi-conductrice de manière à former avec la première couche semi-conductrice une troisième couche semi-conductrice continue (146) et présentant des épaisseurs différentes (T_{Si1}, T_{Si2}).

## Description

### DOMAINE TECHNIQUE DE L'INVENTION

La présente invention concerne en général un procédé de fabrication d'une couche semi-conductrice présentant des épaisseurs différentes et entrant par exemple dans la fabrication de transistors de type métal oxyde semi-conducteur à effet de champs (MOSFET). Une application avantageuse mais non limitative concerne plus particulièrement, la réalisation d'un substrat de type semi-conducteur dont la couche semi-conductrice possède au moins deux épaisseurs distinctes et sur lequel sont formés des transistors logiques et des transistors analogiques.

### ÉTAT DE LA TECHNIQUE

Pour certaines applications microélectroniques, on cherche à former sur une même plaque des paires de transistors appariés, c'est-à-dire des transistors présentant les mêmes caractéristiques électriques. Parmi ces applications figurent par exemple les miroirs de courant.

L'un des paramètres habituellement étudié pour quantifier la dispersion au sein d'une paire de transistors appariés est la différence de leur tension de seuil (VT pour Voltage Threshold). En effet, les variations de tension de seuil induisent notamment des fluctuations de performance et une augmentation de la consommation.

Dans une technologie classique sur silicium massif, la dispersion provient majoritairement des fluctuations de dopants (RDF pour Random-Dopant-Fluctuation). Cette source de dispersion étant aléatoire, elle a tendance à diminuer quand la surface du transistor augmente (moyennage du nombre de dopants).

Pour cette raison, lorsque l'homme du métier cherche à avoir des transistors très bien appariés, il utilise conventionnellement des grands transistors présentant une large surface. En particulier, de grands transistors analogiques sont utilisés en paires pour les structures de définition de référence de courant, les miroirs de courants, les comparateurs de courant, etc.

L'utilisation de la technologie des transistors à effet de champ de type silicium sur isolant complètement déserté (FDSOI pour fully depleted SOI), permet de supprimer certaines sources de variabilité telles que la fluctuation aléatoire de dopants (de l'anglais « Random Dopant Fluctuation », RDF).

Toutefois, la technologie FDSOI introduit une nouvelle source de variabilité entre transistors. En effet l'épaisseur T_{Si} de la fine couche de silicium surmontant le couche isolante du substrat SOI (silicium sur isolant) peut varier d'un dispositif à l'autre et affecte les caractéristiques des transistors. Notamment, des variations de l'épaisseur T_{Si} entraînent des variations significatives de la tension de seuil des transistors disposés à sa surface.

Cette variabilité n'est pas entièrement aléatoire. Les épaisseurs en deux points très éloignés d'une même plaque de SOI ont plus de chances d'être très différentes qu'en deux points proches. Ceci signifie que, au sein d'un groupe de transistors, plus les transistors sont éloignés, plus la variabilité sera forte.

Il apparaît également que plus l'épaisseur T_{Si} de la couche de silicium est fine, plus la tension de seuil fluctue.

Afin d'optimiser la technologie FDSOI, il peut donc être souhaitable d'avoir une épaisseur fine de silicium pour les transistors logiques et une épaisseur plus épaisse pour les transistors analogiques appariés aux transistors logiques (transistors de matching analogiques)

Il conviendrait alors de proposer une solution pour obtenir une couche semi-conductrice présentant deux épaisseurs différentes.

Des solutions ont déjà été recherchées pour y parvenir. Ces solutions proposent de réaliser des empilements de type SOI à partir d'une couche d'oxyde enterrée (Buried Insulating Oxyde, BOX) présentant des épaisseurs différentes. La couche de silicium disposée au dessus de la couche de BOX présente alors également des épaisseurs différentes.

Dans le document US6300218 une couche de BOX est formée par un procédé SIMOX (séparation par implantation d'oxygène) au cours duquel la couche de BOX est épaissie en certaines zones en effectuant une implantation localisée d'oxygène à travers un masque puis un recuit. Différentes épaisseurs de silicium T_{Si} sont alors définies à l'aplomb des différentes épaisseurs de la couche de BOX. Toutefois, avec cette solution il est très délicat de contrôler précisément l'épaisseur de la couche de BOX dans les zones épaissies. En outre, au sein des zones épaissies, on constate une mauvaise uniformité d'épaisseur de la couche de BOX. Enfin, le profil du passage d'une zone épaisse à une zone mince de la couche d'oxyde enterrée n'est pas suffisamment abrupt. Cela augmente l'éloignement minimal des dispositifs qui seront définis sur la couche de silicium, réduisant ainsi la densité d'intégration.

Le brevet américain US6593205 propose un procédé de formation localisée de la couche de BOX qui repose également sur la technologie SIMOX de formation de la couche de BOX par implantation ionique et recuit. Dans cette solution, le procédé comprend une étape d'implantation ionique d'oxygène pour former une couche de dioxyde de silicium, puis une implantation d'ions non solubles dans le dioxyde de silicium à travers un masque. Un recuit est ensuite effectué. Seules les zones n'ayant pas reçues la deuxième implantation forment une couche isolante.

Un inconvénient important de cette invention réside dans l'impossibilité de former une couche d'oxyde enterrée continue. Par ailleurs, il s'avère très délicat de contrôler précisément l'épaisseur et l'uniformité de la couche d'oxyde enterrée.

Le brevet américain US6756257 propose un autre procédé reposant sur la technologie SIMOX. Dans cette solution, on effectue une implantation d'oxygène à travers un masque diélectrique pour faire varier localement la profondeur à laquelle la couche de BOX est réalisée dans le substrat. La couche de silicium située au dessus de la couche de BOX présente donc des variations d'épaisseur. Avec ce procédé il est difficile d'obtenir une jonction abrupte entre deux épaisseurs différentes de silicium. Il est également difficile d'obtenir une bonne uniformité d'épaisseur de la couche d'oxyde enterrée au sein d'une même zone. De plus, même avec un procédé SIMOX optimisé, il est difficile d'éviter la formation de dislocations aux extrémités des épaisseurs de la couche BOX formées localement.

Les paragraphes ci-dessus mentionnent de nombreux inconvénients que présentent les solutions connues. La présente invention vise à apporter une solution pour réduire ou éliminer certains au moins de ces inconvénients.

### RÉSUMÉ DE L'INVENTION

Selon un mode de réalisation, la présente invention propose un procédé de réalisation d'une couche semi-conductrice présentant au moins deux épaisseurs différentes (T_{Si1}, T_{Si2}) et surmontant un substrat et une couche isolante. Le procédé est mis en oeuvre à partir d'un empilement de type semi-conducteur sur isolant comportant au moins un substrat sur lequel sont disposées successivement une couche isolante et une première couche semi-conductrice présentant de préférence une épaisseur homogène. Le procédé comprend au moins une séquence comportant les étapes suivantes:
- gravure locale de la première couche semi-conductrice de manière à ce que la première couche semi-conductrice demeure continue et comprenne au moins une première zone dont l'épaisseur (t_{Si1}) est inférieure à l'épaisseur (t_{Si2}) d'au moins une deuxième zone ; la gravure locale forme ainsi au moins une cavité dans la première couche semi-conductrice ;
- oxydation de la première couche semi-conductrice pour former un film d'oxyde électriquement isolant à la surface de la première couche semi-conductrice de manière à ce que dans la première zone le film d'oxyde s'étende jusqu'à la couche isolante de l'empilement initial et à ce que dans la deuxième zone le film d'oxyde ne s'étende pas jusqu'à la couche isolante ; ainsi, au niveau des premières zones, le film d'oxyde forme, avec la couche isolante de l'empilement initial de type semi-conducteur sur isolant, une couche d'isolation continue depuis le substrat jusqu'à la face libre tournée vers l'extérieur;
- retrait partiel du film d'oxyde de manière à mettre à nu la première couche semi-conductrice en dehors de la première zone et à conserver une partie au moins du film d'oxyde dans la première zone ; le film d'oxyde associé à la couche isolante forme ainsi une surépaisseur d'oxyde au niveau de chaque première zone ;
- formation sur l'empilement de couches d'une deuxième couche semi-conductrice de manière à former avec la première couche semi-conductrice une troisième couche semi-conductrice continue et présentant des zones d'épaisseurs différentes (T_{Si1}, T_{Si2}).
   Ainsi les premières zones ont une épaisseur de couche semi-conductrice égale à T_{Si1} et les deuxièmes zones auront une épaisseur T_{Si2} de couche semi-conductrice égale à T_{Si1} additionnée de l'épaisseur résiduelle de la première couche semi-conductrice (épaisseur de la première couche semi-conductrice restant dans les deuxièmes zones après l'étape de retrait partiel du film d'oxyde).

L'invention propose ainsi un procédé particulièrement simple pour former une couche semi-conductrice présentant différentes épaisseurs à partir d'une couche semi-conductrice d'épaisseur de préférence homogène. Des transistors comprenant des épaisseurs différentes de semi-conducteur peuvent ainsi être intégrés sur une même plaque à partir d'un empilement semi-conducteur sur isolant conventionnel.

De manière avantageuse, l'invention permet d'obtenir pour chaque zone une épaisseur de matériau semi-conducteur uniforme et contrôlée avec précision.

Un autre avantage de l'invention réside dans la possibilité d'obtenir des profils abrupts, c'est-à-dire des jonctions très pentues entre les zones d'épaisseurs différentes. Cela permet notamment d'augmenter la densité d'intégration.

Par ailleurs, il s'est avéré que l'invention permet de réduire voire d'éliminer les défauts à la jonction entre deux zones d'épaisseurs différentes.

En outre, l'invention permet de réaliser une couche semi-conductrice dont la face tournée vers l'extérieur est plane. En effet, les zones épaisses de matériau semi-conducteur ne forment pas saillie en surface. L'empilement de couches obtenu avec l'invention peut ainsi être utilisé avec les procédés standards mettant en oeuvre des empilements de couches dont la surface libre est plane.

L'invention est ainsi particulièrement avantageuse pour co-intégrer des épaisseurs différentes de semi-conducteur pour des technologies de type FDSOI (transistor à effet de champ de type silicium sur isolant complètement déserté) ou Trigate. Selon un autre aspect, la présente invention porte sur un procédé de réalisation d'une couche semi-conductrice présentant au moins deux épaisseurs différentes (T_{Si1}, T_{Si2}) et surmontant un substrat et une couche isolante, à partir d'un empilement de type semi-conducteur sur isolant comportant au moins un substrat, une couche isolante et une première couche semi-conductrice, le procédé comprenant au moins une séquence comportant les étapes suivantes:
- gravure locale de la première couche semi-conductrice de manière à ce que la première couche semi-conductrice soit continue et comprenne au moins une première zone dont l'épaisseur (t_{Si1}) est inférieure à l'épaisseur (t_{Si2}) d'au moins une deuxième zone;
- oxydation de la première couche semi-conductrice pour former un film d'oxyde électriquement isolant à la surface de la première couche semi-conductrice de manière à ce que dans la première zone le film d'oxyde s'étende jusqu'à la couche isolante;
- retrait partiel du film d'oxyde de manière à mettre à nu la première couche semi-conductrice en dehors de la première zone;
- formation sur l'empilement de couches d'une deuxième couche semi-conductrice de manière à former avec la première couche semi-conductrice une troisième couche semi-conductrice continue.
   De préférence, le procédé comprend également la formation de transistors d'un premier type sur la première zone et la formation de transistors d'un deuxième type sur la deuxième zone.

Les autres objets, caractéristiques et avantages de la présente invention apparaîtront à l'examen de la description suivante et des dessins d'accompagnement. Il est entendu que d'autres avantages peuvent être incorporés.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 résume les principales étapes d'un exemple de réalisation de fabrication d'un substrat de type semi-conducteur sur isolant possédant une couche semi-conductrice présentant au moins deux épaisseurs différentes.
La FIGURE 2a illustre la structure de départ d'un empilement de type semi-conducteur sur isolant conventionnel.
La FIGURE 2b illustre la structure obtenue à l'issue de l'étape de gravure locale de la première couche semi-conductrice.
La FIGURE 3 illustre la structure obtenue à l'issue de l'étape de formation d'un film d'oxyde continu par oxydation de la première couche semi-conductrice.
La FIGURE 4 illustre la structure obtenue à l'issue de l'étape de mise à nu de la première couche semi-conductrice dans la zone non gravée et en laissant en place dans la zone gravée une partie du film d'oxyde.
Les FIGURES 5a à 5c illustrent la structure obtenue à l'issue des étapes de formation d'une couche semi-conductrice sur l'empilement.
La FIGURE 6 illustre la structure obtenue à l'issue de l'étape facultative de réalisation d'une tranchée d'isolation à la jonction entre les deux zones d'épaisseurs distinctes de la couche semi-conductrice.
La FIGURE 7 illustre un exemple d'un transistor logique et d'un transistor analogique formés sur des épaisseurs différentes de la couche semi-conductrice de l'empilement.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
Avantageusement, le film d'oxyde présente une épaisseur homogène.

Avantageusement, le retrait partiel du film d'oxyde est effectué de manière à obtenir une surface plane formée par le film d'oxyde dans la au moins une première zone et par la première couche semi-conductrice dans la au moins une deuxième zone.

Avantageusement, le retrait partiel du film d'oxyde comprend une étape de gravure de type mécanique et chimique (CMP). De préférence la gravure est effectuée avec arrêt sur la première couche semi-conductrice. De préférence la gravure est effectuée de manière à former une face plane. Cette face est formée par le film isolant dans la au moins une première zone et par la première couche semi-conductrice dans la au moins une deuxième zone.

Selon un premier mode de réalisation, la deuxième couche semi-conductrice est une couche de matériau semi-conducteur monocristallin. Avantageusement, la formation sur l'empilement de couches d'une deuxième couche semi-conductrice comprend le report d'un film de matériau semi-conducteur cristallin sur l'empilement. De préférence, le report du film de matériau semi-conducteur est effectué par un procédé comprenant le détachement de ce film de matériau semi-conducteur monocristallin par rupture d'une couche plus épaisse au niveau d'une zone de fragilisation d'un substrat donneur de matériau semi-conducteur monocristallin. L'homme du métier pourra se référer pour cela aux nombreux procédés connus de report d'une couche par collage moléculaire.

Selon un deuxième mode de réalisation, la première couche semi-conductrice est cristalline et la formation sur l'empilement de couches d'une deuxième couche semi-conductrice comprend : le dépôt d'une couche de matériau semi-conducteur amorphe sur la première couche semi-conductrice et le film d'oxyde ; un traitement thermique effectué de manière à cristalliser la couche de matériau semi-conducteur amorphe par épitaxie en phase solide à partir de la première couche semi-conductrice.

Avantageusement, la formation sur l'empilement de couches d'une deuxième couche semi-conductrice comprend le dépôt d'une couche semi-conductrice d'épaisseur constante, c'est-à-dire homogène sur toute sa surface, aux imprécisions de fabrications près.

De préférence, la gravure locale de la première couche semi-conductrice comprend, préalablement à la gravure locale, une étape d'oxydation de la première couche semi-conductrice dans les zones à graver et sur une épaisseur correspondant à l'épaisseur à graver. Avantageusement, la cinétique de gravure de l'oxyde est très supérieure à celle du matériau semi-conducteur. L'étape d'oxydation permet ainsi de mieux contrôler l'épaisseur gravée. De manière alternative, on n'effectue pas d'étape d'oxydation préalablement à la gravure.

La gravure localisée est réalisée de manière à ce que la couche semi-conductrice demeure continue. La gravure locale ne consomme donc pas toute l'épaisseur de la couche semi-conductrice, même dans les zones de plus faible épaisseur.

De préférence, après l'étape d'oxydation de la première couche semi-conductrice dans les zones à graver et avant la gravure sélective, on effectue un aplanissement de la surface par polissage CMP par exemple.

La gravure peut par exemple être une gravure par voie humide, par exemple à base d'acide chlorhydrique (HCl). Alternativement, on peut recourir à une gravure sèche, à base par exemple d'une chimie fluorée.

Selon un mode de réalisation, le procédé comprend une seule séquence d'étapes, de manière à définir une couche semi-conductrice présentant uniquement deux zones d'épaisseurs différentes. Selon un mode de réalisation alternatif, le procédé comprend au moins deux séquences d'étapes, de manière à définir une couche semi-conductrice présentant au moins trois zones d'épaisseurs différentes.

Selon un mode de réalisation particulier, le procédé de formation de transistors comprend : la formation d'une couche semi-conductrice présentant au moins deux épaisseurs différentes (T_{Si1}, T_{Si2}) ; la formation d'au moins un transistor d'un premier type au dessus d'au moins une première zone de la couche semi-conductrice ; la formation d'au moins un transistor d'un deuxième type différent du premier type au dessus de la au moins une deuxième zone de la couche semi-conductrice. Ainsi, l'invention permet de former des transistors de types différents en fonction des épaisseurs du matériau semi-conducteur sur lesquels ils sont situés.

De préférence, le procédé comprend la formation de tranchées d'isolation à l'interface entre deux zones d'épaisseurs différentes (T_{Si1}, TSi₂).

Avantageusement, les deux zones sont adjacentes.

Selon un mode de réalisation, au moins un transistor de type logique est formé au dessus de la au moins une première zone et au moins un transistor de type analogique est formé au dessus de la au moins une deuxième zone. De préférence, tous les transistors de type analogique sont formés au dessus de la au moins une deuxième zone, c'est-à-dire sur une épaisseur de semi-conducteur supérieure à l'épaisseur des premières zones.

Selon un mode de réalisation, au moins un transistor à effet de champ de type silicium sur isolant complètement déserté (FDSOI) est formé au dessus de la au moins une première zone. Selon un mode de réalisation, seuls des transistors FDSOI sont formés sur la première zone.

Selon un mode de réalisation, au moins un transistor de type Trigate également désigné Triple-Gate ou Tri-gate est formé au dessus de la deuxième zone.

Selon un mode de réalisation, un transistor de type Trigate est formé au-dessus de la deuxième zone dont l'épaisseur est importante, préférentiellement supérieure que 10 nm (nanomètre), tandis qu'un transistor de type FDSOI est formé au-dessus de la première zone dont l'épaisseur est plus mince. L'invention permet ainsi de co-intégrer ces deux types de transistors.

Selon un mode de réalisation particulier, des transistors Tri-gate sont formés dans une zone de forte épaisseur et dans une zone de faible épaisseur. De préférence, ces zones sont adjacentes. Cela permet d'avoir des transistors Tri-gate de hauteur différente et possiblement très proches les uns des autres. L'invention offre ainsi une liberté plus grande pour la valeur du courant.

Avantageusement, la première portion d'épaisseur T_{Si1} de la couche semi-conductrice est destinée à former un premier canal pour un premier transistor. La deuxième portion d'épaisseur de la couche semi-conductrice est destinée à former un deuxième canal pour un deuxième transistor. La surépaisseur d'oxyde est effectuée de manière à ce que la largeur de cette surépaisseur soit supérieure ou égale à la somme des largeurs d'un empilement de grille et de source et drain qui lui sont associés.

De préférence, la gravure locale de la première couche semi-conductrice comprend, préalablement à la gravure, une étape de lithographie pour protéger avec un masque les zones qui ne seront pas gravées.

Avantageusement, la première couche semi-conductrice est à base de silicium ou de germanium. La première couche semi-conductrice également désignée couche active de l'empilement semi-conducteur sur isolant est une couche en silicium, en germanium ou en silicium-germanium. De préférence, la deuxième couche semi-conductrice est une couche en silicium, en germanium ou en silicium-germanium.

De préférence, on prévoit pour la première couche semi-conductrice et la deuxième couche semi-conductrice des matériaux identiques. Alternativement, on prévoit pour la première couche semi-conductrice et la deuxième couche semi-conductrice des matériaux présentant des paramètres de maille qui diffèrent de moins de 1% et de préférence de moins de 0.5% dans le plan parallèle à la face du substrat.

De préférence, la couche isolante initiale est une couche d'oxyde enterrée de l'empilement de couches de type semi-conducteur sur isolant. De préférence, la première couche semi-conductrice est la couche active de l'empilement de couches de type semi-conducteur sur isolant.

De préférence, le transistor est un transistor de type MOSFET (Transistor à effet de champ).

La présente invention est particulièrement adaptée pour les substrats de type semi-conducteur sur isolant, tels que les substrats élaborés de type silicium-sur- isolant (SOI) avec une couche d'oxyde enterrée (Buried Insulating Oxyde, BOX) mince. En effet, grâce à l'invention l'épaisseur de la couche isolante initiale est conservée, aucune gravure de la BOX initiale n'étant nécessaire pour l'obtention de source et drain enterrés.

Il est précisé que dans le cadre de la présente invention, le terme « sur » « surmonte » ou « sous jacent » ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans le cadre de la présente invention on qualifie d'épaisseur homogène, une épaisseur qui est homogène, notamment pour les films les plus minces, en tous points de la couche ou qui ne varie pas de plus de 1 nm et de préférence pas de plus de 0.5 nm sur toute la surface de la couche. Typiquement, cette variation d'épaisseur est involontaire. Elle résulte par exemple des imprécisions inhérentes au procédé de formation ou d'amincissement de la couche de semi-conducteur.

Typiquement, dans le cadre de la présente invention, la couche de semi-conducteur initiale, c'est-à-dire la couche de semi-conducteur du substrat de type semi-conducteur sur isolant à partir duquel le procédé selon l'invention est mis en oeuvre, présente une épaisseur qui ne varie pas de plus de 2nm. Par exemple, l'épaisseur initiale est de 10nm.

Dans le cadre de la présente invention on qualifie d'épaisseurs différentes, les épaisseurs des zones d'une couche qui diffèrent de par exemple 2 nm ou plus lorsque l'épaisseur moyenne de la couche est de 5nm. Cette différence des épaisseurs des zones est plus importante que des fluctuations locales de par exemple plus ou moins 0.5 nm sur l'épaisseur moyenne de cette couche qui fait par exemple 5 nm d'épaisseur.

A l'issue du procédé selon l'invention, deux zones de la couche de semi-conducteur présentent des épaisseurs respectives par exemple de 5 et 10 nm ou de 5 et 7 nm.

De manière non limitative des zones d'épaisseurs différentes sont des zones qui présentent une différence d'épaisseur d'au moins 15%, de préférence d'au moins 20% et de préférence d'au moins 50%.

Dans le cadre de la présente invention on qualifie de largeur des dimensions prises selon une direction parallèle au plan de la face inférieure d'un substrat 112 et selon la direction de déplacement des électrons dans un canal 180. On qualifie d'épaisseur une dimension prise selon une direction perpendiculaire au plan de la face inférieure du substrat 112. Ainsi, sur les figures illustrées les épaisseurs sont prises selon une direction verticale et les largeurs sont prises selon une direction horizontale.

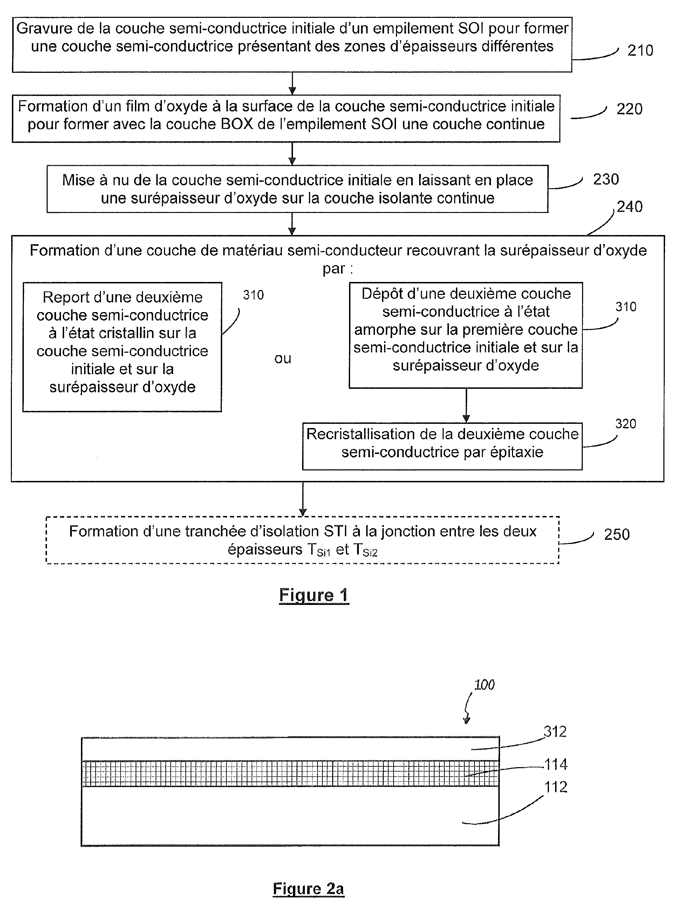

Le mode de réalisation qui va maintenant être décrit propose un procédé de fabrication d'un empilement de couches de type semi-conducteur sur isolant dont la couche active en matériau semi-conducteur présente au moins deux épaisseurs différentes T_{Si1} et T_{Si2}. La **figure 1** résume les principales étapes de fabrication d'un tel empilement. Ces étapes seront ensuite décrites avec plus de détails en référence aux **figures 2a à 7****.** Seules deux épaisseurs T_{Si1} et T_{Si2} et deux transistors 200 et 500 seront illustrés sur ces figures afin de faciliter la compréhension de l'invention. Naturellement un nombre plus élevé d'épaisseurs et un nombre plus élevé de transistors peuvent être réalisés sur une même plaque.

La figure 2a représente un empilement 100 de type semi-conducteur sur isolant conventionnel, par exemple de type SOI (silicium sur isolant). Ainsi, la structure de départ comporte un substrat 112, souvent désigné substrat porteur ou substrat de base, une couche isolante 114 (mince ou épaisse), le plus souvent une couche d'oxyde enterré (BOX pour Buried Oxyde en anglais) et une couche semi-conductrice 312 située sur la couche isolante 114. Cette couche semi-conductrice 312 est qualifiée dans la suite de la description de première couche semi-conductrice 312. De préférence, l'épaisseur de la première couche semi-conductrice 312 au début du procédé est homogène. Avantageusement, l'épaisseur de la couche 114 ne constitue pas une contrainte pour la réalisation de l'invention. De manière avantageuse, l'empilement 100 étant conventionnel, la couche isolante 114 présente une épaisseur constante et sa face supérieure est plane.

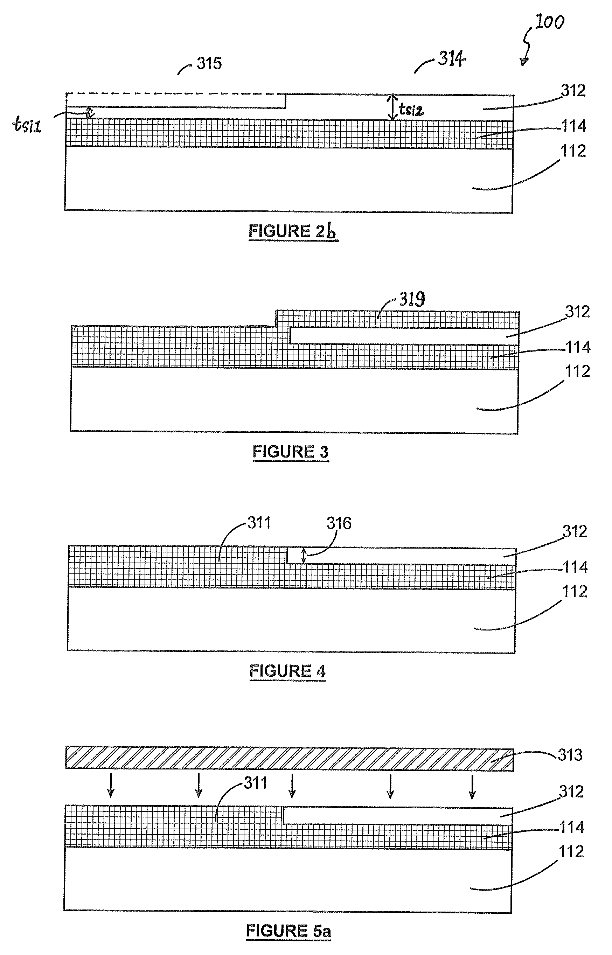

La **figure 2b** illustre la structure obtenue à l'issue de l'étape 210 comprenant une gravure de la couche semi-conductrice 312. La gravure est plus forte dans des premières zones référencées 315 qui forment alors des cavités ou des creux que dans des deuxièmes zones référencées 314 qui forment alors des saillies. Dans un mode de réalisation particulier, les zones 314 de la couche semi-conductrice 312 ne sont pas gravées. Dans un autre mode de réalisation, ces zones 314 sont gravées mais de manière moins profonde que les zones 315. Sur la figure 2b, les pointillés illustrent l'épaisseur de matériau qui a été prélevée sur les premières zones 315 et qui n'a pas été prélevée sur les deuxièmes zones.

Ainsi, les zones 315 présentent une épaisseur t_{Si1} inférieure à l'épaisseur t_{Si2} des zones 314. Cette différence d'épaisseur forme une marche à la surface de l'empilement 100.

La gravure est de préférence comprise entre 5 et 20 nm (nanomètre). La gravure est définie de manière à laisser en place du matériau semi-conducteur dans les zones 315 les plus profondément gravées. De préférence, une épaisseur de la couche semi-conductrice 312 de l'ordre de 1 à plusieurs nm est conservée dans le fond des premières zones 315. Le matériau semi-conducteur est par exemple du silicium, du germanium ou du silicium-germanium.

Pour graver localement la première couche semi-conductrice 312, on peut réaliser au préalable une étape de lithographie pour former un masque résistant à la gravure et recouvrant les zones 314 que l'on ne souhaite pas graver.

Selon le premier mode de réalisation particulier, la gravure de la couche semi-conductrice 312 est réalisée directement à travers le masque.

Selon un autre mode de réalisation, la gravure de la couche 312 est réalisée après une oxydation de la couche 312 à travers un masque masquant les deuxièmes zones 314. Cette étape d'oxydation oxyde ainsi les zones 315 non protégées par le masque. De préférence, on effectue ensuite une étape d'aplanissement de la surface externe de l'empilement obtenu après l'oxydation localisée (par CMP par exemple). On effectue ensuite une gravure sélective des zones oxydées par rapport aux zones non oxydées ou moins oxydées. Cette gravure comprend par exemple une gravure avec une solution à base d'acide chlorhydrique (HCl). Selon un autre mode de réalisation, une gravure sèche, par exemple à base d'une chimie fluorée est également envisageable.

Cette étape d'oxydation permet de contrôler très précisément l'épaisseur que l'on souhaite graver, en tirant profit de la forte sélectivité à la gravure de l'oxyde par rapport au matériau semi-conducteur. L'épaisseur d'oxydation définit alors directement l'épaisseur des zones de la couche 312 à graver par la suite. On notera que l'oxydation tend à augmenter la taille des motifs à graver, il faut donc prendre cela en compte lors de l'étape de définition des dimensions des premières 315 et deuxièmes 314 zones.

La **figure 3** illustre la structure obtenue à l'issue de l'étape 220 de formation d'un film d'oxyde 319 continu par oxydation de la couche semi-conductrice 312 à partir de sa face tournée vers l'extérieur. Une oxydation thermique est effectuée pour former un film d'oxyde 319 continu sur la surface découverte de la première couche semi-conductrice 312. Le masque ou la couche de résine utilisés pour effectuer la définition des premières 315 et deuxièmes 314 zones aura préalablement été retiré.

Les paramètres d'oxydation, notamment la durée d'oxydation, sont à définir de manière à oxyder la totalité de l'épaisseur de la couche semi-conductrice 312 au niveau des premières zones 315. Ainsi, toute la couche 312 située au droit des zones 315 est oxydée. Le film d'oxyde 319 formé dans la zone 314 s'étend donc jusqu'à la couche isolante 114. Une marche, comme illustré en figure 3, est formée à la jonction entre la couche déjà oxydée 312 au droit des zones 315 et le film d'oxyde 319. Le film d'oxyde 319 forme avec la couche isolante 114 une couche ininterrompue ou continue d'oxyde qui est constituée par un matériau isolant.

L'oxydation peut élargir la taille des premières zones 315 de la première couche semi-conductrice 312, ce qui ce n'est pas gênant en soi. Il faut alors simplement anticiper cela dès l'étape 210 pour définir la largeur des motifs du masque et des premières zones 315 à graver avant oxydation.

La **figure 4** illustre la structure obtenue à l'issue de l'étape 230 de mise à nu de la couche semi-conductrice 312 en laissant en place dans les zones 315 le film d'oxyde 319. Ce film d'oxyde 319 forme ainsi une couche 311 d'oxyde à la surface de la couche isolante 114 de l'empilement initial. La couche 311 constitue une surépaisseur. Ces surépaisseurs peuvent également être qualifiées de plots d'oxyde. Cette étape 230 consiste à retirer les zones oxydées surmontant la première couche semi-conductrice 312 en réalisant un polissage, tel qu'un polissage mécano-chimique CMP, acronyme de l'anglais « Chemical-Mechanical Polishing ». Le polissage CMP s'arrête de préférence sur la couche 312 encore présente dans la deuxième zone 314. Ainsi, après CMP il n'y a plus d'oxyde surmontant la couche 312 et la couche 312 est donc totalement découverte. Seule demeure la couche 311. De préférence, la face libre de l'empilement, c'est-à-dire la face supérieure sur les figures, est plane sur l'ensemble de la plaque. L'épaisseur 316 de la couche 311 est sensiblement égale de celle de la couche semi-conductrice 312 qui demeure après CMP.

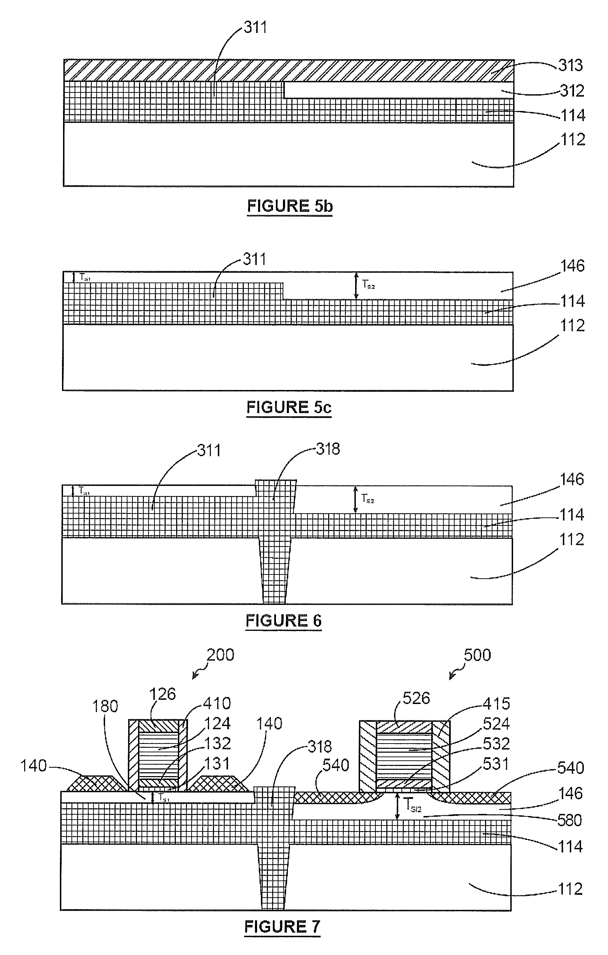

Ensuite, les **figures 5a à 5c** illustrent la structure obtenue à l'issue de l'étape 240 de formation d'une couche semi-conductrice ininterrompue ou continue 146 recouvrant la couche 311. L'étape 240 comprend l'une étape 310 du mode de réalisation illustré en figure 5a ou l'étape 320 du mode de réalisation illustré en figure **5****b.** La **figure 5c** illustre la structure obtenue à l'issue de chacun de ces deux modes de réalisation.

L'étape 310, illustrée en **figure 5a****,** consiste à déposer une couche 313 destinée à former un canal 180 pour des transistors 200 réalisés sur une faible épaisseur de la couche semi-conductrice (voir la figure 7). La couche 313 est en un matériau semi-conducteur, avantageusement cristallin, en silicium par exemple. L'épaisseur de la couche 313 est de préférence comprise entre 5 et 20 nm. De manière avantageuse, cette couche 313 est rapportée sur l'empilement comportant la couche 311 depuis une autre structure, tel qu'un substrat donneur. Pour effectuer ce report, on peut par exemple utiliser les techniques bien connues de l'homme du métier telles que le collage moléculaire ou la rectification (de l'anglais « Grinding (abrasive cutting) ») ayant fait l'objet de nombreuses publications. Typiquement, la couche semi-conductrice 313 est un film mince que l'on détache d'un substrat donneur en ayant au préalable créé dans ce substrat donneur une zone de fragilisation, par exemple par implantation ionique.

La couche semi-conductrice 312 et la couche semi-conductrice 313 forment une couche semi-conductrice ininterrompue ou continue 146, comme illustré en **figure 5c****.** La couche semi-conductrice ininterrompue ou continue 146 comprend deux portions d'épaisseurs distinctes (T_{Si1} et T_{Si2}) qui pourront ensuite former deux canaux 180 et 580 pour deux transistors 200 et 500 comme cela sera décrit plus bas.

Dans ce mode de réalisation, de préférence, la couche semi-conductrice 312 et la couche semi-conductrice 313 sont monocristallines.

Après dépôt de la couche 313 on ajuste l'épaisseur de la couche semi-conductrice 146 finale en effectuant un polissage CMP. Ainsi on ajuste l'épaisseur T_{Si1} de la deuxième couche semi-conductrice 313 située au-dessus du de la surépaisseur 311. Cette étape peut être optionnelle.

Ce mode de réalisation est particulièrement avantageux pour obtenir un canal monocristallin sans défaut dans la structure cristalline, y compris au milieu des canaux 180 et 580. Les canaux 180 et 580 sont donc homogènes et présentent une structure cristalline sans défauts ou avec un nombre de défauts limité.

Selon l'autre méthode, la couche semi-conductrice ininterrompue ou continue 146 est reformée par dépôt de la couche semi-conductrice 313 en phase amorphe et par Epitaxie en phase solide, habituellement désignée par son vocable anglais « Solid Phase Epitaxy ». Le matériau semi-conducteur amorphe de la couche 313 est déposé, à une température par exemple de 400°C, sur les couches 311 et les portions restantes de la première couche semi-conductrice 312.

La **figure 5b** illustre la structure obtenue au cours de l'étape 320 de recristallisation du matériau semi-conducteur de la couche 313 amorphe, recristallisation amorcée à partir de la structure cristalline de la couche semi-conductrice 312 présente dans les zones 314.

Dans le cas où ce matériau est du silicium amorphe, un traitement thermique est effectué à une température préférentielle de 500°C, pour qu'une recristallisation du silicium amorphe de la couche 313 soit amorcée par le matériau semi-conducteur cristallin de la couche 312. Ainsi, une couche semi-conductrice 146 cristalline est formée comme illustré en **figure 5c****.** De préférence, la couche 312 est monocristalline et la couche 146 obtenue après recristallisation de la couche 313 est également monocristalline.

L'empilement illustré en **figure 5c** présente ainsi une structure semi-conducteur sur isolant, avec comme particularité que la couche semi-conductrice présente des épaisseurs différentes et que la couche isolante est continue. La couche isolante 114 présente également des épaisseurs différentes.

On remarquera que la jonction entre les zones de forte épaisseur et de faible épaisseur est abrupte.

On remarquera également que la face tournée vers l'extérieur de la couche semi-conductrice 146 est plane quand bien même cette couche comporte des épaisseurs différentes. Pour effectuer les étapes ultérieures de définition des structures, l'empilement peut donc être manipulé et traité de la même manière qu'un empilement SOI conventionnel.

Cet empilement est par exemple prêt pour la réalisation des empilements de grille pour former le transistor logique 200 et le transistor analogique 500 apparié avec le transistor logique 200.

Dans certaines applications, il peut être souhaitable d'avoir une meilleure isolation électrique entre les deux zones d'épaisseurs T_{Si1} et T_{Si2}. Une tranchée d'isolation 318 à la jonction entre les deux épaisseurs T_{Si1} et T_{Si2} peut alors être réalisée, comme illustré en **figure 6****.**

La **figure 6** illustre la structure obtenue à l'issue de l'étape facultative 250 ci-dessus de réalisation d'une tranchée d'isolation 318. La tranchée d'isolation 318 est de préférence une tranchée d'isolation de type STI (acronyme de l'anglais Shallow Trench Isolation signifiant tranchée d'isolation de faible profondeur ou tranchée d'isolation de surface).

La couche semi-conductrice 146 comprend deux portions isolées : la couche semi-conductrice 146 d'épaisseurs T_{Si1} et la couche semi-conductrice 146 d'épaisseurs T_{Si2}.

Grâce à la formation de la couche semi-conductrice 146 d'épaisseurs distinctes T_{Si1} et T_{Si2}, comme illustré en **figures 5c et 6****,** des transistors à effet de champ de type silicium sur isolant complètement déserté (FDSOI) et trigate peuvent être réalisés sur la même plaque et de manière très rapprochée. Typiquement, un transistor de type FDSOI est formé au dessus de la portion d'épaisseur T_{Si1} et un transistor de type Trigate est formé au dessus de la portion d'épaisseur T_{Si2}, T_{Si2} étant supérieur à T_{Si1}.

Selon un mode de réalisation particulier, des transistors Tri-gate sont formés dans la zone de forte épaisseur T_{Si2} et la zone de plus faible épaisseur T_{Si1}. Cela permet d'avoir des transistors Tri-gate de hauteur différente et adjacents.

De plus, une paire de transistors logique-analogique exigeant deux épaisseurs différentes de la couche semi-conductrice 146 peut être également réalisée sur la même plaque illustrée en **figures 5c ou 6****.**

La **figure 7** illustre un exemple de transistor logique 200 et de transistor analogique 500 formés respectivement sur les épaisseurs T_{Si1} et T_{Si2} de la couche semi-conductrice 146 du substrat SOI.

L'empilement de grille du transistor logique 200, réalisé en dessus de la portion d'épaisseur T_{Si1} de la couche semi-conductrice 146, comporte par exemple les couches suivantes empilées depuis la couche semi-conductrice 146: une couche d'isolation de la grille, souvent désignée oxyde mince de grille 131 ou couche high-k, une couche métallique 132, une grille 124 également désignée électrode de grille et un masque dur 126 recouvrant la surface supérieure de la grille 124.

Des couches de protection, habituellement désignées espaceurs 410, sont situées de part et d'autre de l'empilement de grille, s'étendent principalement perpendiculairement au plan du substrat 112 et recouvrent les flancs de la grille 124 au moins. Ils sont avantageusement faits de nitrure de silicium. Le masque dur 126 et les espaceurs 410 protègent l'empilement de grille pour que les flancs de l'empilement de grille ne soient pas gravés lors des opérations qui pourraient suivre. En particulier, comme cela apparaîtra dans la suite de la description, le masque dur 126 et les espaceurs 410 sont faits de matériaux résistant aux produits de gravure.

L'empilement de grille du transistor analogique 500 est réalisé en dessus de la portion d'épaisseur T_{Si2} de la couche semi-conductrice 146. La structure du transistor analogique 500 comprend de préférence le même empilement que celui du transistor logique 200. Selon un mode de réalisation, l'empilement de grille du transistor analogique 500 peut comprendre : une couche d'isolation de la grille 531, , une couche métallique 532, une grille 524 et un masque dur 526 recouvrant la surface supérieure de la grille 524.

Les empilements de grille sont réalisés de manière conventionnelle, par exemple par une succession de lithographies et de gravures.

Avantageusement, les canaux 180 et 580, respectivement formés par les deux portions d'épaisseurs distinctes T_{Si1} et T_{Si2} de la couche semi-conductrice 146, sont un matériau semi-conducteur monocristallin.

Des source et drain 140 du transistor logique 200 et ceux du transistor analogique 500 sont également réalisés de manière conventionnelle. De préférence, des source et drain 140 sont formés de part et d'autre de la grille 124 en dessus de la face supérieure de la couche semi-conductrice 146 d'épaisseur T_{Si1}.

Des source et drain 540 du transistor analogique 500, illustrés en **figure 7****,** sont formés de part et d'autre de l'empilement de grille 524 et au sein de la portion d'épaisseur T_{Si2} de la couche semi-conductrice 146, par implantation ionique ou par dopage par exemple.

L'invention n'est pas limitée aux empilements de grille décrits ci-dessus et certaines des couches mentionnées ci-dessous peuvent ne pas être présentes ou d'autres couches peuvent être rajoutées sans pour autant sortir du cadre de la présente invention.

Au vu de la description qui précède, il apparaît clairement que la présente invention offre une solution simple et fiable pour former une couche semi-conductrice présentant différentes épaisseurs. En outre, l'invention procure les avantages suivants:
- elle permet d'améliorer le contrôle de l'uniformité et de l'épaisseur de la couche semi-conductrice finale. Les étapes d'oxydation, de gravure et de polissage CMP permettent d'obtenir un dimensionnement précis des structures. L'uniformité, l'épaisseur et la taille des surépaisseurs 311 de la couche isolante 114 sont mieux maîtrisées qu'avec les solutions basées sur des étapes d'implantation et de recuit par SIMOX.
- le profil de la couche isolante 114 à la jonction entre deux épaisseurs différentes T_{Si1} et T_{Si2} est abrupt. Il est donc possible de rapprocher les transistors disposés de part et d'autre de la jonction. La densité d'intégration est donc améliorée.
- l'invention permet également de réduire le nombre de défauts à la jonction entre deux épaisseurs différentes T_{Si1} et T_{Si2} de la couche isolante 114.
- en outre, l'invention permet la formation directe d'une surface planaire de type semi-conducteur sur isolant commune à la couche semi-conductrice 146 surplombant deux épaisseurs distinctes T_{Si1} et T_{Si2} de la couche isolante 114.

On notera que si dans le mode de réalisation décrit ci-dessus la couche semi-conductrice finale comporte uniquement deux épaisseurs, on pourra prévoir plus de deux épaisseurs différentes pour une même couche semi-conductrice.

Pour cela, on répétera par exemple plusieurs séquences comprenant chacune les étapes 210 à 310. Pour une séquence on pourra notamment effectuer la gravure locale de l'étape 210 sur une portion seulement de la zone déjà gravée localement lors d'une séquence précédente.

Selon un autre mode de réalisation, la première couche semi-conductrice 312 de l'empilement initial ne présente pas une épaisseur homogène.

De préférence, et comme représenté sur les figures, la couche isolante 114 présente une face directement au contact du substrat 112. De préférence, et comme représenté sur les figures, la couche isolante 114 présente une face directement au contact de la première couche semi-conductrice 312 puis de la couche semi-conductrice 146 obtenue en fin de procédé.

L'invention n'est pas limitée aux modes de réalisation précédemment décrits mais s'étend à tous modes de réalisation couverts par les revendications.

## Revendications

1. Procédé de réalisation d'une couche semi-conductrice (146) présentant au moins deux épaisseurs différentes (T_{Si1}, T_{Si2}) à partir d'un empilement (100) de type semi-conducteur sur isolant comportant au moins un substrat (112) sur lequel sont disposées successivement une couche isolante (114) et une première couche semi-conductrice (312), le procédé comprenant au moins une séquence comportant les étapes suivantes:
• gravure de la première couche semi-conductrice (312) de manière à ce que la première couche semi-conductrice (312) soit continue et comprenne au moins une première zone (315) dont l'épaisseur (t_{Si1}) est inférieure à l'épaisseur (t_{Si2}) d'au moins une deuxième zone (314) ;
• oxydation de la première couche semi-conductrice (312) pour former un film d'oxyde (319) électriquement isolant à la surface de la première couche semi-conductrice (312) de manière à ce que dans la première zone (315) le film d'oxyde (319) s'étende jusqu'à la couche isolante (114) et à ce que dans la deuxième zone (314) le film d'oxyde (319) ne s'étende pas jusqu'à la couche isolante (114) ;
• retrait partiel du film d'oxyde (319) de manière à mettre à nu la première couche semi-conductrice (312) en dehors de la première zone (315) et à conserver une partie au moins du film d'oxyde (319) dans la première zone (315) ;
• formation sur l'empilement de couches d'une deuxième couche semi-conductrice (313) de manière à former avec la première couche semi-conductrice (312) une troisième couche semi-conductrice continue (146) et présentant des épaisseurs différentes (T_{Si1}, T_{Si2}).

2. Procédé selon la revendication précédente dans lequel le retrait partiel du film d'oxyde (319) est effectué de manière à obtenir une surface plane formée par : le film d'oxyde (319) dans la au moins une première zone (315) et par la première couche semi-conductrice (312) dans la au moins une deuxième zone (314), et dans lequel le retrait partiel du film d'oxyde (319) comprend de préférence une étape de gravure de type mécanique et chimique (CMP).

3. Procédé selon l'une quelconque des revendications précédentes dans lequel la deuxième couche semi-conductrice (313) est une couche de matériau semi-conducteur monocristallin.

4. Procédé selon l'une quelconque des revendications précédentes dans lequel la formation d'une deuxième couche semi-conductrice (313) comprend le report d'un film de matériau semi-conducteur cristallin sur la première couche semi-conductrice (312) et sur le film d'oxyde (319).

5. Procédé selon l'une quelconque des revendications 1 à 2 dans lequel la première couche semi-conductrice (312) est cristalline et dans lequel la formation d'une deuxième couche semi-conductrice (313) comprend :
- le dépôt d'une couche de matériau semi-conducteur (313) amorphe sur la première couche semi-conductrice (312) et le film d'oxyde (319),
- un traitement thermique effectué de manière à cristalliser la couche de matériau semi-conducteur (313) amorphe par épitaxie en phase solide à partir de la première couche semi-conductrice (312).

6. Procédé selon l'une quelconque des revendications précédentes dans lequel ladite gravure de la première couche semi-conductrice (312) de manière à ce que la première couche semi-conductrice (312) soit continue et comprenne au moins une première zone (315) dont l'épaisseur (t_{Si1}) est inférieure à l'épaisseur (t_{Si2}) d'au moins une deuxième zone (314) comprend : une étape préalable d'oxydation de la première couche semi-conductrice (312) uniquement dans la au moins une première zone (315) et une étape ultérieure de gravure sélective du matériau semi-conducteur oxydé par rapport au matériau semi-conducteur non oxydé.

7. Procédé selon l'une quelconque des revendications précédentes comprenant une seule séquence d'étapes, de manière à définir une couche semi-conductrice (146) présentant uniquement deux zones d'épaisseurs différentes (T_{Si1}, TSᵢ₂).

8. Procédé selon l'une quelconque des revendications 1 à 6 comprenant au moins deux séquences d'étapes, de manière à définir une couche semi-conductrice présentant au moins trois zones d'épaisseurs différentes.

9. Procédé selon l'une quelconque des revendications 1 à 8 dans lequel on prévoit pour la première couche semi-conductrice (312) et la deuxième couche semi-conductrice (313) des matériaux différents et présentant des paramètres de maille qui diffèrent de moins de 1% et de préférence de moins de 0.5% dans le plan parallèle à la face du substrat.

10. Procédé de formation de transistors comprenant :
- la formation d'une couche semi-conductrice (146) présentant au moins deux épaisseurs différentes (T_{Si1}, T_{Si2}) selon l'une quelconque des revendications précédentes ;
- la formation d'au moins un transistor (200) d'un premier type au dessus d'au moins une première zone (315) de la couche semi-conductrice (146);
- la formation d'au moins un transistor (500) d'un deuxième type différent du premier type au dessus d'au moins une deuxième zone (314) de la couche semi-conductrice (146), l'épaisseur de la couche semi-conductrice (146) dans la première zone étant différente de l'épaisseur de la couche semi-conductrice (146) dans la deuxième zone (315).

11. Procédé selon la revendication précédente comprenant la formation de tranchées d'isolation (318) à l'interface entre deux zones d'épaisseurs différentes (T_{Si1}, T_{Si2}) et dans lequel les première (315) et deuxième (314) zones sont de préférence adjacentes ou séparées par une tranchée d'isolation (318).

12. Procédé selon l'une quelconque des deux revendications précédentes dans lequel au moins un transistor de type logique (200) est formé au dessus de la au moins une première zone (315) et au moins un transistor de type analogique (500) est formé au dessus de la au moins une deuxième zone (314).

13. Procédé selon l'une quelconque des trois revendications précédentes dans lequel au moins un transistor à effet de champ de type silicium sur isolant complètement déserté (FDSOI) est formé au dessus de la au moins une première zone (315), l'épaisseur de la couche semi-conductrice (146) dans la première zone (315) étant inférieure à l'épaisseur de la couche semi-conductrice (146) dans la deuxième zone (314).

14. Procédé selon l'une quelconque des quatre revendications précédentes dans lequel au moins un transistor de type Trigate (Tri-gate) est formé au dessus de la au moins une deuxième zone (314), l'épaisseur de la couche semi-conductrice (146) dans la première zone (315) étant inférieure à l'épaisseur de la couche semi-conductrice (146) dans la deuxième zone (314).

15. Procédé selon l'une quelconque des cinq revendications précédentes dans lequel on prévoit pour la première couche semi-conductrice (312) et la deuxième couche semi-conductrice (313) des matériaux identiques.
